Europäisches Patentamt

European Patent Office

Office européen des brevets

(11) Publication number: **0 045 563**
**B1**

(12) **EUROPEAN PATENT SPECIFICATION**

(45) Date of publication of patent specification: **05.12.84**

(21) Application number: **81302973.3**

(22) Date of filing: **30.06.81**

(51) Int. Cl.³: **C 22 C 19/05, C 30 B 21/02**

(54) Nickel-base alloy for single crystal casting.

(30) Priority: **25.07.80 GB 8024471**

(43) Date of publication of application:
**10.02.82 Bulletin 82/06**

(45) Publication of the grant of the patent:
**05.12.84 Bulletin 84/49**

(84) Designated Contracting States:
**DE FR GB**

(56) References cited:
FR-A-2 141 003
GB-A-1 011 785
GB-A-1 229 549
GB-A-1 380 870
GB-A-1 557 900
US-A-3 283 377

**The file contains technical information
submitted after the application was filed and
not included in this specification**

(73) Proprietor: **The Secretary of State for Defence in
Her Britannic Majesty's Government of The
United Kingdom of Great Britain and
Northern Ireland Whitehall
London SW1A 2HB (GB)**

(72) Inventor: **Winstone, Michael Ronald
5 York Crescent
Aldershot Hampshire (GB)**

(74) Representative: **Robinson, Frederick Robert
et al
Procurement Executive Ministry of Defence
Patents 1 A (4) Room 1932, 19th Floor Empress
State Building, Lillie Road
London SW6 1TR (GB)**

Courier Press, Leamington Spa, England.

## Description

This invention relates to nickel base alloys which are particularly suitable for the production of castings which comprises a single crystal.

To secure desirable mechanical properties in components operating in a high temperature environment, notably blades for gas turbines, it can be advantageous that the blades are cast in the form of single crystals. However, alloys commonly used for the production of gas turbine blades have been essentially developed to give equiaxed polycrystalline castings and the proportions of constituents are not considered to be ideal to give the best results in single crystal castings.

The present invention seeks by varying the said proportions to optimise compositions which will result in substantial improvements in the properties of single crystals.

According to the present invention a nickel-based alloy is characterised in that the composition lies within the ranges expressed below in weight per cent:

Cr 8 to 10 — W 0 to 11 — Ti 1.3 to 1.8 — B 0 to 0.02 — Zr 0 to 0.1 — C 0 to 0.08 — Co 4 to 11 — Ta 3.7 to 5.3 — Al 5.25 to 6.2 — Ni Balance.

A commercial alloy taken as a starting point contains 1.5% hafnium in its standard specification. Work has indicated that hafnium is not required in single crystal castings and its presence is detrimental to creep properties and consequently hafnium has been omitted from alloys according to the invention other than as an impurity.

Alloy compositions by weight per cent which have been produced are as follows:—

| Alloy Code | C | Cr | Co | W | Ta | Mo | Nb | Al | Ti | Hf | Zr | B |
|---|---|---|---|---|---|---|---|---|---|---|---|---|
| Control | 0.15 | 9 | 10 | 10 | 2.5 | — | — | 5.5 | 1.5 | 1.5 | 0.05 | 0.015 |
| SX 80 | 0.02 | 9.5 | 10.3 | 10.3 | 2.6 | — | — | 5.8 | 1.5 | — | 0.05 | 0.01 |
| SX 78 | 0.06 | 9 | 10 | 10 | 4.0 | — | — | 5.5 | 1.5 | — | 0.05 | 0.01 |
| SX 77 | 0.02 | 9 | 10 | 10 | 4.0 | — | — | 5.5 | 1.5 | — | 0.05 | 0.01 |
| SX 60 | 0.02 | 9 | 10 | 10 | 4.0 | — | — | 5.5 | 1.5 | — | — | — |
| SX 56 | 0.02 | 9 | 10 | 10 | 5.0 | — | — | 5.5 | 1.5 | — | 0.05 | 0.01 |
| SX 53 | 0.02 | 9 | 5 | 10 | 4.0 | — | — | 5.5 | 1.5 | — | 0.05 | 0.01 |
| N1 | 0.17 | 16 | 8.5 | 2.6 | 1.75 | 1.75 | 0.9 | 3.4 | 3.4 | — | 0.10 | 0.01 |
| N2 | 0.15 | 22.4 | 19 | 2 | 1.4 | — | 1 | 1.9 | 3.7 | — | 0.10 | 0.01 |
| N3 + Hf | 0.21 | 12.5 | 9 | 3.9 | 3.9 | 2 | — | 3.2 | 4.2 | 1.5 | 0.10 | 0.02 |

In the case of the alloy coded as SX 53 the cobalt content has been reduced. In the not unlikely event of a cobalt shortage due to political considerations there would be considerable advantage in a high strength nickel based super alloy having relatively less cobalt in its composition than the accepted standard. In all alloys other than SX 80 the proportion of tantalum has been increased compared with the control alloy. Zirconium and boron are omitted in SX 60. This is to raise the incipient melting point of the alloy and allow a full solution treatment.

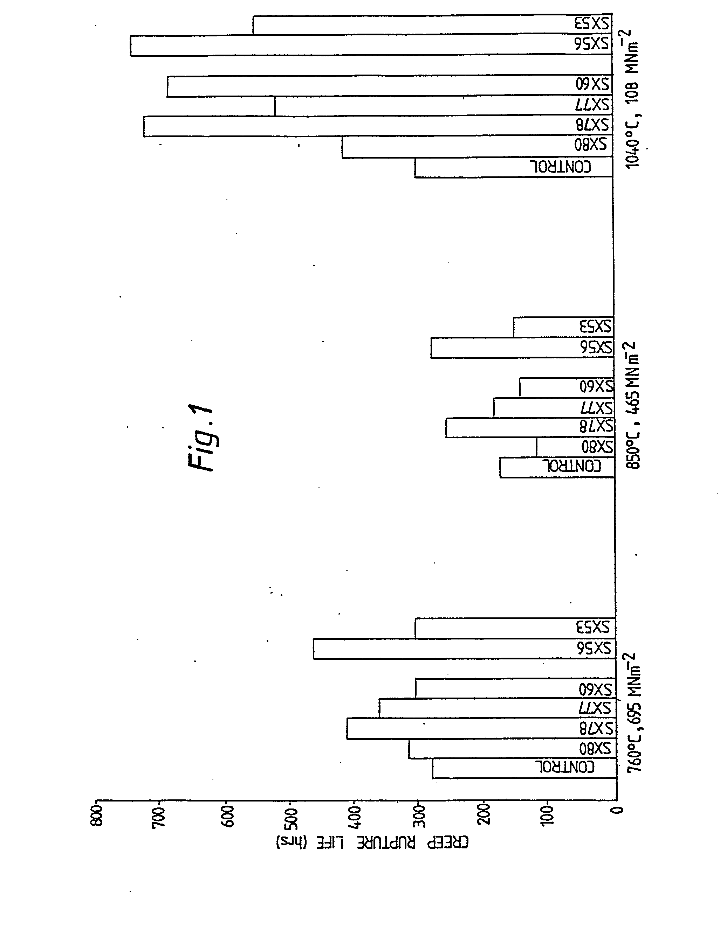

Examples of all alloys have been produced and alloys SX 80, SX 78 and SX 77 have been cast as single crystals. Mechanical tests have shown excellent creep rupture properties. Fig. 1 compares the alloys with the control alloy when cast as single crystals. Creep rupture life is in general much improved at 1040°C, at least twice (equivalent to a 19° temperature advantage) in most cases. The superior strength is maintained down to 760°C and also up to 1100°C (not shown).

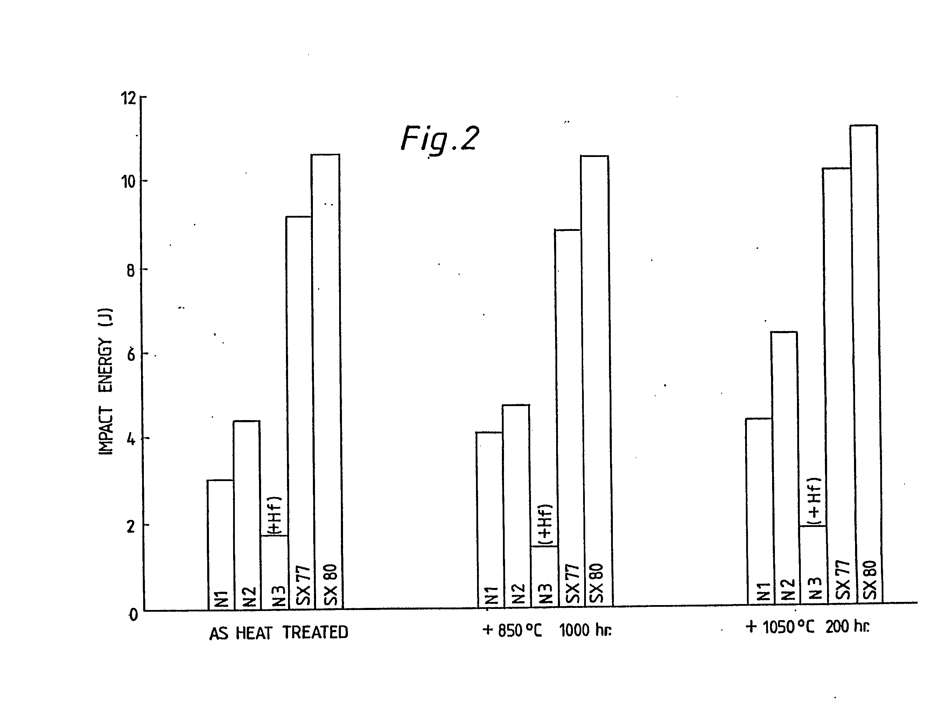

Charpy impact tests have shown that SX 77 and SX 80 have very high impact resistance compared with certain commercial alloys (not the control), as shown in Fig. 2. The alloys N1, N2 and N3 + Hf are commercial alloys widely used for the production of polycrystalline gas turbine engine components. The compositions of N1, N2 and N3 + Hf are given in the table above.

This impact resistance was not severely degraded after long term heat treatment and metallography has not shown evidence of precipitation of harmful TCP phases which might indicate structural instability.

## Claims

1. A nickel-based alloy characterised in that the composition lies within the ranges expressed below in weight per cent:

| | |
|---|---|
| chromium | 8 to 10 |
| tungsten | 0 to 11 |
| titanium | 1.3 to 1.8 |
| boron | 0 to 0.02 |
| zirconium | 0 to 0.1 |
| carbon | 0 to 0.08 |
| cobalt | 4 to 11 |
| tantalum | .3.7 to 5.3 |
| aluminium | 5.25 to 6.2 |
| nickel | balance |

2. A nickel-based alloy according to claim 1 characterised in that the composition comprises in weight per cent:

| | |
|---|---|
| chromium | 9 |
| tungsten | 10 |
| titanium | 1.5 |
| carbon | 0.02 |
| cobalt | 9 |
| tantalum | 4 |
| aluminium | 5.5 |
| nickel | balance |

3. A nickel-based alloy according to claim 2 characterised in that the composition further comprises:

| | |
|---|---|
| zirconium | 0.05 |
| boron | 0.01 |

4. A nickel-based alloy according to claim 3 characterised in that the chromium content is increased to 10 weight per cent.

5. A nickel-based alloy according to claim 3 characterised in that the tungsten content is decreased to 5 weight per cent.

6. A nickel-based alloy according to claim 3 characterised in that the carbon content is increased to 0.06 weight per cent.

7. A nickel-based alloy according to claim 3 characterised in that the cobalt content is reduced to 5 weight per cent.

8. A nickel-based alloy characterised in that the composition comprises in weight per cent:

| | |
|---|---|
| chromium | 9.5 |
| tungsten | 10.3 |
| titanium | 1.5 |
| boron | 0.01 |
| zirconium | 0.05 |
| carbon | 0.02 |
| cobalt | 10.3 |
| tantalum | 2.6 |
| aluminium | 5.8 |
| nickel | balance |

## Revendications

1. Alliage à base de nickel, caractérisé en ce que la composition se situe dans les gammes exprimées ci-dessous, en pourcentages, en poids:

| | |
|---|---|
| Chrome: | 8 à 10 |
| Tungstène: | 0 à 11 |
| Titane: | 1,3 à 1,8 |
| Bore: | 0 à 0,02 |
| Zirconium: | 0 à 0,1 |
| Carbone: | 0 à 0,08 |
| Cobalt: | 4 à 11 |
| Tantale: | 3,7 à 5,3 |
| Aluminium: | 5,25 à 6,2 |
| Nickel: | le reste. |

2. Alliage à base de nickel selon la revendication 1, caractérisé en ce que la composition comporte en pourcentages en poids:

| | |
|---|---|
| Chrome: | 9 |
| Tungstène: | 10 |
| Titane: | 1,5 |
| Carbone: | 0,02 |
| Cobalt: | 9 |
| Tantale: | 4 |
| Aluminium: | 5,5 |
| Nickel: | le reste. |

3. Alliage à base de nickel selon la revendication 2, caractérisé en ce que la composition comprend en outre:

| | |
|---|---|
| Zirconium: | 0,05 |
| Bore: | 0,01 |

4. Alliage à base de nickel selon la revendication 3, caractérisé en ce que la teneur en chrome est accrue jusqu'à 10 % en poids.

5. Alliage à base de nickel selon la revendication 3 caractérisé en ce que la teneur en tungstène est réduite à 5 % en poids.

6. Alliage à base de nickel selon la revendication 3 caractérisé en ce que la teneur en carbone est accrue jusqu'à 0,06 % en poids.

7. Alliage à base de nickel selon la revendication 3 caractérisé en ce que la teneur en cobalt est réduite à 5 % en poids.

8. Alliage à base de nickel caractérisé en ce que la composition comprend en pourcentages en poids:

| | |
|---|---|
| Chrome: | 9,5 |
| Tungstène: | 10,3 |
| Titane: | 1,5 |
| Bore: | 0,01 |
| Zirconium: | 0,05 |
| Carbone: | 0,02 |
| Cobalt: | 10,3 |
| Tantale: | 2,6 |
| Aluminium: | 5,8 |
| Nickel: | le reste. |

**Patentansprüche**

1. Nickelbasislegierung, dadurch gekennzeichnet, daß ihre Zusammensetzung innerhalb der nachstehend in Gewichtsprozent angegebenen Bereiche liegt:

| Chrom | 8 bis 10 |
|---|---|
| Wolfram | 0 bis 11 |
| Titan | 1,3 bis 1,8 |
| Bor | 0 bis 0,02 |
| Zirconium | 0 bis 0,1 |
| Kohlenstoff | 0 bis 0,08 |
| Kobalt | 4 bis 11 |
| Tantal | 3,7 bis 5,3 |
| Aluminium | 5,25 bis 6,2 |
| Nickel | Rest |

2. Nickelbasislegierung nach Anspruch 1, dadurch gekennzeichnet, daß die Zusammensetzung in Gewichtsprozent enthält:

| Chrom | 9 |
|---|---|
| Wolfram | 10 |
| Titan | 1,5 |
| Kohlenstoff | 0,02 |
| Kobalt | 9 |
| Tantal | 4 |
| Aluminium | 5,5 |
| Nickel | Rest |

3. Nickelbasislegierung nach Anspruch 2, dadurch gekennzeichnet, daß ihre Zusammensetzung außerdem enthält:

| Zirconium | 0,05 |
|---|---|
| Bor | 0,01 |

4. Nickelbasislegierung nach Anspruch 3, dadurch gekennzeichnet, daß der Chromgehalt auf 10 Gewichtsprozent erhöht ist.

5. Nickelbasislegierung nach Anspruch 3, dadurch gekennzeichnet, daß der Wolframgehalt auf 5 Gewichtsprozent vermindert ist.

6. Nickelbasislegierung nach Anspruch 3, dadurch gekennzeichnet, daß der Kohlenstoffgehalt auf 0,06 Gewichtsprozent erhöht ist.

7. Nickelbasislegierung nach Anspruch 3, dadurch gekennzeichnet, daß der Kobaltgehalt auf 5 Gewichtsprozent vermindert ist.

8. Nickelbasislegierung, dadurch gekennzeichnet, daß ihre Zusammensetzung in Gewichtsprozent enthalt:

| Chrom | 9,5 |
|---|---|
| Wolfram | 10,3 |
| Titan | 1,5 |
| Bor | 0,01 |
| Zirconium | 0,05 |
| Kohlenstoff | 0,02 |
| Kobalt | 10,3 |
| Tantal | 2,6 |
| Aluminium | 5,8 |
| Nickel | Rest |

Fig.1

CREEP RUPTURE LIFE (hrs)

760°C, 695 MNm⁻²

CONTROL
SX80
SX78
SX77
SX60
SX56
SX53

850°C, 465 MNm⁻²

CONTROL
SX80
SX78
SX77
SX60
SX56
SX53

1040°C, 108 MNm⁻²

CONTROL
SX80
SX78
SX77
SX60
SX56
SX53

0 045 563

*Fig.2*

0045 563